# FASCICULE DE BREVET EUROPEEN

(11) **EP 0 498 713 B1**
(45) Date de publication et mention de la délivrance du brevet: **07.09.1994**
(21) Numéro de dépôt: 92400279.3
(22) Date de dépôt: 04.02.1992
(51) Int. Cl.: H05K 3/34

(54) **Procédé de montage sur un substrat souple de composants électroniques miniatures à pattes de connexion à souder**
Montageverfahren für elektronische Miniaturkomponenten mit lötbaren Anschlussbeinchen auf ein flexibles Substrat
Process of mounting miniature electronic components with solderable leads on a flexible substrate

(30) Priorité: 05.02.1991 FR 9101270
(43) Date de publication de la demande: 12.08.1992
(73) Titulaire: THOMSON-CSF, 75008 Paris (FR)
(72) Inventeur: Roche, Pascal, F-75008 Paris (FR); Courtin, Claude, F-75008 Paris (FR)
(74) Mandataire: Beylot, Jacques

(56) Documents cités:
- DE-A- 1 001 361
- MICROWAVE JOURNAL. vol. 30, no. 8, Août 1987, DEDHAM US,pages 119 - 132;I. K.GREENSHIELDS 'PRACTICAL BONDING TECHNIQUES FOR BEAM-LEAD DIODES'
- RESEARCH DISCLOSURE. no. 300, Avril 1989, HAVANT GB page 284 'PIEZOELECTRIC THERMODE FOR THERMOCOMPRESSION SHEAR BONDING'
- PATENT ABSTRACTS OF JAPAN vol. 14, no. 222 (E-926)(4165) 10 Mai 1990 & JP-A-02 054 991
- ELECTRONIQUE APPLICATIONS. no. 61, Août 1988, PARIS FR pages 65 - 73 'CARTES IMPRIMEES POUR MONTAGE EN SURFACE MATERIAUX ET PROCEDES NOUVEAUX'

## Description

L'invention concerne le montage, sur un substrat souple, de composants électroniques miniatures à pattes de connexion à souder du genre connu sous la désignation anglosaxonne "beam lead", qui présentent des pattes de connexion droites en forme de minuscules poutres disposées dans le plan de leur face inférieure.

Jusqu'à présent, il était très délicat, voire impossible, de monter un composant "beam lead" sur un substrat souple sans risquer, à plus ou moins long terme, une rupture du composant ou des soudures de ses pattes de connexion en raison de tractions exercées sur ces dernières par l'intermédiaire du substrat souple. Les premiers défauts peuvent apparaître lors du montage du composant et les suivants au cours du fonctionnement du matériel ainsi équipé. Dans le premier cas, la rupture est due, en général, à un enfoncement du substrat lors du soudage de la deuxième patte ou des suivantes ce qui provoque une forte traction sur la ou les pattes de connexion déjà soudées ; le reste du temps, la rupture est due à une traction sur les pattes de connexion du composant provoquée en général, par l'écart entre les coefficients de dilatation thermique du substrat, d'une part, et du matériau semiconducteur constituant le composant d'autre part. Enfin, tout effort mécanique sollicitant le substrat souple en tension est susceptible de provoquer le même phénomène de rupture en raison de la fragilité des composants "beam lead" due à leur très petite taille et de l'agencement de leurs pattes de connexion.

L'invention a pour but de neutraliser les effets des contraintes mécaniques de divers provenances, notamment thermique, qui apparaissent sur les pattes de connexion des composants "beam lead" après leur soudage sur un substrat souple.

L'invention a pour objet un procédé de montage, sur un substrat souple, de composants électroniques miniatures à pattes de connexion à souder, de forme droite, disposées dans le plan de la face inférieure des composants, consistant, après avoir soudé au moyen d'un outil de soudage une première patte de connexion d'un composant sur une zone métallisée du substrat, à cambrer chacune des autres pattes du composant pendant leur soudage, en appuyant l'extrémité de la patte considérée sur une zone métallisée du substrat au moyen de la pointe de l'outil de soudage tout en effectuant avec cette dernière pointe un léger mouvement de rapprochement vers le corps du composant considéré, provoquant le rippage de cette patte de connexion en direction du corps du composant et son cambrage avant de procéder au soudage proprement dit.

Le mouvement de rapprochement de la pointe de l'outil à souder alors qu'elle est appuyée sur l'extrémité d'une patte de connexion provoque le rippage de cette dernière en direction du corps du composant et son cambrage. Grâce à ce cambrage de leurs pattes de connexion, les composants électroniques miniatures ne sont plus plaqués au substrat avec leurs pattes de connexion en extension mais arqués sur ces dernières, ce qui leur procure une liberté de débattement en leur permettant de s'aplatir plus ou moins sur le substrat en fonction des tendances à la dilatation ou à la rétraction de celui-ci.

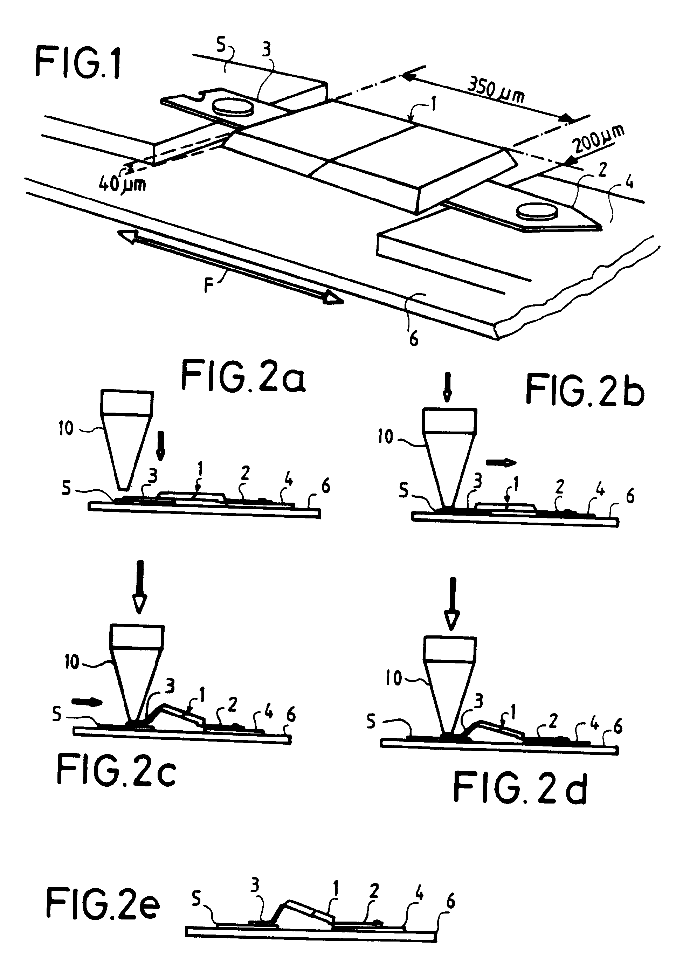

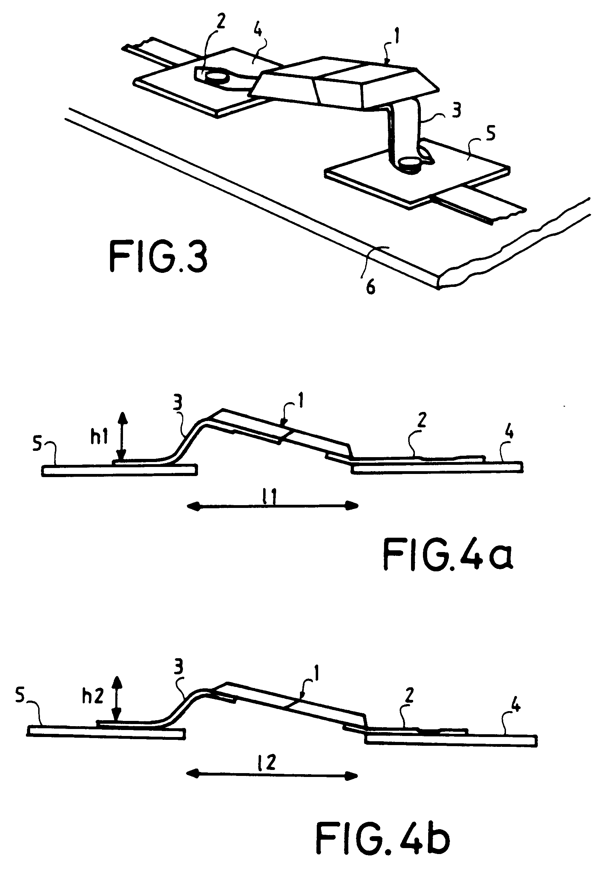

D'autres caractéristiques et avantages de l'invention ressortiront de la description ci-après d'un mode de mise en oeuvre donné à titre d'exemple. Cette description sera faite en regard du dessin dans lequel :
- une figure 1 représente, en perspective, un composant électronique "beam lead" monté sur un substrat à la manière de l'art antérieur ;
- des figures 2a, b, c, d, e illustrant les différentes étapes du procédé de montage selon l'invention ;
- une figure 3 représente, en perspective, un composant électronique "beam lead" monté sur un substrat par mise en oeuvre du procédé de montage selon l'invention et
- des figures 4a et b, représentent, vu de profil, un composant électronique "beam lead" monté sur un substrat souple avec le procédé selon l'invention et illustrent la liberté de débattement de ce composant vis à vis des déformations du substrat.

Dans le dessin, les mêmes éléments ont été indexés sur les différentes figures par les mêmes références.

On distingue sur la figure 1, un composant "beam lead" 1 à deux pattes de connexion 2, 3 monté à plat, à la manière de l'art antérieur, entre deux plages métallisées 4, 5 du substrat souple 6.

Ce composant "beam lead", qui est une diode dans l'exemple considéré, est de très petite taille puisqu'il se présente sous la forme d'une pastille rectangulaire de 350 µm de long par 200 µm de large et environ 40 µm d'épaisseur. Ses pattes de connexion 2, 3 sont constituées, comme pour tout composant "beam lead" de minuscules languettes droites ou poutres disposées dans le plan de sa face inférieure. Lorsqu'il est soudé sans précautions particulières, il se retrouve plaqué contre le substrat 6, ses deux pattes de connexion 2, 3 fixées en extension entre les deux plages métallisées 4, 5.

La moindre dilatation du substrat souple 6 selon l'axe F tendant à écarter les deux plages métallisées 4, 5 engendre un effort de traction s'exerçant entre les pattes de connexion 2, 3 du composant. Comme celui-ci est en extension, il n'a pas d'autre solution que de supporter cette traction. En fait, étant donnée sa fragilité due à ses faibles dimensions et à la nature des matériaux le constituant (verre + silicium), il a tendance à se briser ou à voir se rompre ses pattes de connexion ou leur soudure.

Dans la pratique, le substrat souple 6 peut être sujet à des dilatations à de nombreuses occasions par exemple lors du soudage de la deuxième patte de connexion en raison d'un enfoncement localisé du à l'appui de la pointe de l'outil de soudage ou lors de manipulations par suite d'un effort exercé sur le substrat souple 6 ou encore lors du fonctionnement du matériel ainsi équipé par suite de variations thermiques. Il en résulte de nombreuses occasions de bris de composants "beam lead " implantés sur un substrat souple.

Selon l'invention, on neutralise les efforts de traction auxquels peut être soumis un composant "beam lead" monté sur un substrat souple par un cambrage de ses pattes de connexion grâce à un procédé de montage particulier dont les principales étapes sont illustrées aux figures 2a à 2e.

Dans ces figures, le composant "beam lead" 1 est supposé être déjà en place sur le substrat souple 6 avec une première patte de connexion 2 soudée à une zone métallisée 4 de manière classique, par exemple, grâce à un soudage par thermocompression, les pattes de connexion 2, 3 et les zones métallisées étant en or.

La figure 2a illustre une phase initiale de positionnement de la pointe chauffante 10 de l'outil de soudage par thermocompression au-dessus de l'extrémité de la deuxième patte de connexion 3 du composant "beam lead" 1 qui est en place sur la zone métallisée 5 à laquelle elle doit être soudée.

La figure 2b illustre le début d'une phase de rippage où la pointe chauffante 10 de l'outil de soudage est appliquée sur l'extrémité de la deuxième patte de connexion 3 avec une pression insuffisante pour le soudage mais suffisante pour agripper cette extrémité, puis la déplacer en direction du corps du composant " beam lead " 1.

La figure 2c illustre la fin de la phase de rippage alors que la deuxième patte de connexion 3 a été cambrée par le mouvement de rapprochement de la pointe chauffante 10 de l"outil de soudage vers le corps du composant "beam lead" 1.

La figure 2d illustre la phase de soudage proprement dite de la deuxième patte de connexion 3 du composant "beam lead" 1 qui consiste à déclancher le chauffage de la pointe de l'outil tout en renforçant la pression d'appui de la pointe chauffante 10 de l'outil de soudage après son immobilisation pour provoquer la soudure.

La figure 2e illustre la disposition finale du composant "beam lead" 1 sur le substrat souple 6 telle qu'elle résulte de la mise en oeuvre du procédé de montage précédent. On remarque que le composant "beam lead" 1 n'est plus plaqué au substrat souple 6 mais arqué sur sa patte de connexion 3.

La figure 3 illustre bien la position relevée qu'adopte le composant "beam lead" 1 à la suite du procédé de montage qui vient d'être décrit. Cette position relevée permet au composant " beam lead " 1, comme montré aux figures 4a et 4b, d'absorber les contraintes mécaniques susceptibles d'être appliquées par le substrat souple 6 entre ses pattes de connexion 2, 3 en s'aplatissant plus ou moins, ce qui lui était impossible de faire lorsqu'il était monté à plat avec ses pattes de connexion 2, 3 en extension. Ainsi, pour un écartement 12 des plages métallisées 4, 5 supérieur à un écartement 11, le composant "beam lead" 1 se relèvera d'une hauteur h2 moindre que la hauteur h1 adoptée pour l'écartement 11 tout en ne subissant qu'un effort de traction résiduel négligeable.

Le procédé de montage de composants "beam lead" sur substrat souple qui vient d'être décrit s'applique également aux composants "beam lead" ayant plus de deux pattes de connexion, ceux ci ayant alors une première patte de connexion soudée de manière classique pour assurer leur maintien en place sur le substrat, et leurs autres pattes de connexion cambrées avant d'être soudées grâce à un rippage de la pointe de l'outil de soudage. Il permet une diminution importante du bris des composants "beam lead" au cours du soudage sur un substrat souple, une plus grande facilité de report de ces composants sur ces substrats et une augmentation importante de la fiabilité en service de ce type de composants soudés sur ces substrats. De plus, sa mise en oeuvre est quasiment gratuite car effectuée eu moment du soudage en utilisant un outil de soudage standard.

## Revendications

1. Procédé de montage, sur un substrat souple (6) de composants électroniques miniatures (1) à pattes de connexion (2, 3) à souder de forme droite, disposées dans le plan de la surface inférieure des composants caractérisé en ce qu'il consiste, après avoir soudé au moyen d'un outil de soudage une première patte de connexion (2) à une zone métallisée (4) du substrat (6), à cambrer chacune des autres pattes de connexion (3) pendant leur soudage en appuyant l'extrémité de la patte de connexion considérée (3) sur une zone métallisée (5) du substrat (6) au moyen de la pointe (10) de l'outil de soudage tout en effectuant, avec cette dernière pointe (10) un mouvement de rapprochement vers le corps du composant considéré (1), provoquant le rippage de cette patte de connexion en direction du corps du composant et son cambrage avant de procéder au soudage proprement dit.

2. Procédé selon la revendication 1, caractérisé en ce que ladite pointe (10) est la pointe chauffante d'un outil de soudage par thermocompression.

## Patentansprüche

1. Verfahren zum Anbringen elektronischer Miniaturbauteile (1) mit anzulötenden Anschlußlaschen (2, 3) mit gerader Form, die in der Ebene der unteren Fläche der Bauelemente angeordnet sind, dadurch gekennzeichnet, daß es darin besteht, daß nach dem Anlöten einer ersten Anschlußlasche (2) an einer metallisierten Zone (4) des Substrats (6) mittels eines Lötwerkzeugs jede der anderen Anschlußlaschen (3) während ihres Anlötens gewölbt wird, indem das Ende der betrachteten Anschlußlasche (3) mittels der Spitze (10) des Lötwerkzeugs in Anlage an eine metallisierte Zone (5) des Substrats (6) gebracht wird, wobei mit letzterer Spitze (10) eine Bewegung der Annäherung an den Körper des betrachteten Bauelements (1) ausgeführt wird, so daß das Verschieben dieser Anschlußlasche in Richtung zum Körper des Bauelements und ihr Wölben vor dem eigentlichen Lötvorgang hervorgerufen werden.

2. Verfahren nach Anspruch 1, dadurch gekennzeichnet, daß die Spitze (10) die Heizspitze eines Thermokompressions-Lötwerkzeugs ist.

## Claims

1. Process for the mounting, on a flexible substrate (6), of miniature electronic components (1) with connecting tabs (2, 3) to be welded, which tabs are of rectilinear shape and are disposed in the plane of the lower surface of the components, characterized in that it consists, after having welded a first connecting tab (2), by means of a welding tool, to a metallized zone (4) of the substrate (6), in raising each one of the other connecting tabs (3) during their welding by pressing the end of the connecting tab under consideration (3) onto a metallized zone (5) of the substrate (6) by means of the tip (10) of the welding tool while effecting, with the latter tip (10), an approach movement towards the body of the component under consideration (1), causing the deflection of this connecting tab in the direction of the body of the component and its raising, before proceeding with the welding per se.

2. Process according to Claim 1, characterized in that said tip (10) is the heating tip of a thermocompression welding tool.
